# EUROPEAN PATENT APPLICATION

(11) **EP 4 851 595 A1**
(43) Date of publication of application: **09.12.2026**
(21) Application number: 25751080.0
(22) Date of filing: 13.01.2025
(51) Int. Cl.: G01K 7/34, G01R 27/26, G01R 27/02

(54) **HEAT SOURCE TYPE IDENTIFICATION METHOD AND APPARATUS, DEVICE, AND STORAGE MEDIUM**

(30) Priority: 06.02.2024 CN 202410167941
(71) Applicant: Southern University of Science and Technology, Shenzhen, Guangdong 518055 (CN)
(72) Inventor: LIU, Weishu, Shenzhen, Guangdong 518055 (CN); SUN, Wenting, Shenzhen, Guangdong 518055 (CN); ZHANG, Pengxiang, Shenzhen, Guangdong 518055 (CN); WANG, Yupeng, Shenzhen, Guangdong 518055 (CN); LIN, Xinyi, Shenzhen, Guangdong 518055 (CN); LI, Zhiqian, Shenzhen, Guangdong 518055 (CN); LI, Shanwu, Shenzhen, Guangdong 518055 (CN)
(74) Representative: KIPA AB
(86) International application number: PCT/CN2025/072080
(87) International publication number: WO 2025/167478

(57) **Abstract**

A heat source type identification method and apparatus, a device, and a storage medium. In the process of a capacitive temperature sensor sensing the external temperature, bulk capacitance and bulk resistance of the capacitive temperature sensor are continuously acquired to obtain bulk capacitance and bulk resistance of the capacitive temperature sensor at each acquisition moment; capacitance change information formed by the bulk capacitance at the moments is calculated, and an ion relaxation time of an ionic thermoelectric gel is calculated on the basis of the bulk capacitance and the bulk resistance; and a heat source type is identified on the basis of the capacitance change information and the ion relaxation time. There are correspondences between bulk capacitance as well as bulk resistance and heat source types; the use of a capacitive temperature sensor can acquire a temperature, and can also identify the type of a heat source that causes the temperature.

## Description

### TECHNICAL FIELD

The present disclosure relates to the technical field of temperature measurement, and in particular to a method and apparatus for heat-source type identification, a device, and a storage medium.

### BACKGROUND

A temperature may be measured by a temperature sensor, and corresponding temperature control may be achieved based on the measured temperature. However, the temperature measured in the prior art is merely a magnitude of the temperature, and a type of a heat source that generates the temperature cannot be identified, that is, temperature measurement in the prior art is limited to the magnitude of the temperature. The types of heat sources include thermal radiation, thermal convection, and thermal conduction. In the thermal radiation, the heat source exchanges heat with an object based on the principle of blackbody radiation, and since there is no direct contact, only a temperature stimulus affects the object; for example, the sun as the heat source is the thermal radiation type. The thermal convection occurs when a fluid interacts with the object, and generates the temperature stimulus and a slight pressure stimulus; for example, an air gun as the heat source that blows hot air to heat the object is the thermal convection type. When the heat source and the object are in direct contact, a proximity stimulus, the pressure stimulus, and the temperature stimulus are generated to affect the object, which means that the heat source is the thermal conduction type.

In summary, the prior art can only measure the magnitude of the temperature and cannot identify the type of the heat source that generates the temperature.

Therefore, the prior art still needs to be improved and enhanced.

### SUMMARY

In order to solve the above technical problem, the present disclosure provides a method and apparatus for heat-source type identification, a device, and a storage medium, which solves the problem that the prior art can only measure the magnitude of the temperature and cannot identify the type of the heat source that generates the temperature.

The present disclosure adopts following technical solutions to achieve the above purpose.

In a first aspect, the present disclosure provides a method and apparatus for heat-source type identification, a device, and a storage medium. The method includes:
during a process in which a capacitive temperature sensor senses an external temperature, collecting a bulk capacitance of the capacitive temperature sensor and a bulk resistance of the capacitive temperature sensor, and determining capacitance change information of the bulk capacitance;
determining, based on the bulk capacitance and the bulk resistance, an ionic relaxation time of ionic gel of the capacitive temperature sensor; and
identifying, based on the capacitance change information and the ionic relaxation time, a heat-source type corresponding to the external temperature.

In an embodiment, the determining capacitance change information of the bulk capacitance includes:
determining increase or decrease information of a capacitance value of the bulk capacitance over time; and
determining, based on the increase or decrease information of the capacitance value over time, a positive or negative change direction of the bulk capacitance, and using the positive or negative change direction as the capacitance change information.

In an embodiment, the determining, based on the bulk capacitance and the bulk resistance, an ionic relaxation time of ionic gel of the capacitive temperature sensor includes:
multiplying the bulk capacitance by the bulk resistance to obtain the ionic relaxation time.

In an embodiment, the identifying, based on the capacitance change information and the ionic relaxation time, a heat-source type corresponding to the external temperature includes:
determining, based on the ionic relaxation time, a temperature value at each time instant corresponding to the external temperature;
determining, based on the temperature value at each time instant, temperature stability corresponding to the external temperature; and
identifying, based on the temperature stability and the capacitance change information, the heat-source type corresponding to the external temperature.

In an embodiment, the identifying, based on the temperature stability and the capacitance change information, the heat-source type corresponding to the external temperature includes:
in response to the temperature stability being unstable and the capacitance change information being zero, determining that the heat-source type is thermal radiation; or
in response to the temperature stability being unstable and the capacitance change information being a positive-capacitance change, determining that the heat-source type is thermal convection; or
in response to the temperature stability being unstable and the capacitance change information being an alternation between a negative-capacitance change and the positive-capacitance change, determining that the heat-source type is thermal conduction.

In an embodiment, the capacitive temperature sensor is prepared by:
using methoxy polyethylene glycol diacrylate (mPEG-DA) as a solvent and lithium bis(pentafluoroethylsulfonyl)imide (Li-PFSI) as a solute, stirring and mixing the solvent and the solute to form a mixture;
placing the mixture on a first electrode, and curing the mixture until the mixture is cured into the ionic gel; and
attaching a second electrode onto the ionic gel to form the capacitive temperature sensor.

In an embodiment, the capacitive temperature sensor is tested by:
performing heat transfer between a test heat source with a known heat-source type and the capacitive temperature sensor, collecting a test bulk capacitance of the capacitive temperature sensor and a test bulk resistance of the capacitive temperature sensor, and determining test capacitance change information of the test bulk capacitance;
determining, based on the test bulk capacitance and the test bulk resistance, an ionic relaxation test time of the ionic gel of the capacitive temperature sensor;
determining, based on the test capacitance change information and the ionic relaxation test time, a heat-source test type of the external temperature; and
obtaining, based on the heat-source test type and the known heat-source type, a test result for the capacitive temperature sensor.

In a second aspect, an embodiment of the present disclosure provides an apparatus for heat-source type identification, which includes:
an information collection module configured to: during a process in which a capacitive temperature sensor senses an external temperature, collect a bulk capacitance of the capacitive temperature sensor and a bulk resistance of the capacitive temperature sensor, and determine capacitance change information of the bulk capacitance;
an ionic relaxation time calculation module configured to: determine, based on the bulk capacitance and the bulk resistance, an ionic relaxation time of ionic gel of the capacitive temperature sensor; and
an identification module configured to: identify, based on the capacitance change information and the ionic relaxation time, a heat-source type corresponding to the external temperature.

In a third aspect, an embodiment of the present disclosure provides a terminal device, which includes a memory, a processor, and a program for heat-source type identification that is stored in the memory and executable by the processor. When the processor executes the program for heat-source type identification, steps of the above method for heat-source type identification are implemented.

In a fourth aspect, an embodiment of the present disclosure provides a computer-readable storage medium, which stores a program for heat-source type identification. When the program for heat-source type identification is executed by a processor, the steps of the above method for heat-source type identification are implemented.

Beneficial effects: in the present disclosure, during the process in which the capacitive temperature sensor senses the external temperature, the bulk capacitance and bulk resistance of the capacitive temperature sensor are continuously collected, so as to obtain the bulk capacitance and bulk resistance of the capacitive temperature sensor at each collection time instant. Thereafter, the capacitance change information formed by the bulk capacitance at each time instant is calculated, and the ionic relaxation time of the ionic gel is calculated based on the bulk capacitance and the bulk resistance. Since the temperatures generated by different types of heat sources cause a change in the bulk capacitance and a change in the bulk resistance, and further cause different ionic relaxation times, the ionic relaxation time may reflect the magnitude of the external temperature sensed by the capacitive temperature sensor, and the magnitude of the external temperature may characterize whether the heat source exists, there is a corresponding relationship between the bulk capacitance and bulk resistance and the heat-source type. Therefore, the present disclosure may identify the heat-source type based on the bulk capacitance, the bulk resistance, and the change information of the bulk capacitance. In summary, the present disclosure may collect the magnitude of the temperature and identify the type of the heat-source that generates the temperature by using the capacitive temperature sensor.

### BRIEF DESCRIPTION OF DRAWINGS

FIG. 1 is an overall flow chart of the present disclosure.
FIG. 2 is a schematic diagram showing a structure of a capacitive temperature sensor in an embodiment of the present disclosure.
FIG. 3 is a schematic diagram showing three heat exchange manners (i.e., thermal radiation, thermal convection, and thermal conduction) in an embodiment of the present disclosure.
FIG. 4 is a schematic diagram showing a corresponding relationship between the thermal radiation and a temperature signal, corresponding relationship between the thermal radiation and a capacitance signal, corresponding relationship between the thermal convection and the temperature signal, corresponding relationship between the thermal convection and the capacitance signal, corresponding relationship between the thermal conduction and the temperature signal, and corresponding relationship between the thermal conduction and the capacitance signal in an embodiment of the present disclosure.
FIG. 5 is an ionic relaxation characteristic diagram of the capacitive temperature sensor in an embodiment of the present disclosure.
FIG. 6 is a schematic diagram showing a relationship between a bulk resistance and a temperature, relationship between a bulk capacitance and the temperature, and relationship between an ionic relaxation time and the temperature in an embodiment of the present disclosure.
FIG. 7 is a schematic diagram showing a response of the capacitive temperature sensor to a heat-source temperature change of 0.005°C in an embodiment of the present disclosure.
FIG. 8 is a schematic diagram showing a capacitance response caused by the temperature in an embodiment of the present disclosure.
FIG. 9 is a schematic diagram showing changes in the ionic relaxation time and normalized capacitance of the capacitive temperature sensor under only a temperature stimulus in an embodiment of the present disclosure.
FIG. 10 is a schematic diagram showing changes in the ionic relaxation time and normalized capacitance of the capacitive temperature sensor under only a pressure stimulus in an embodiment of the present disclosure.
FIG. 11 is a schematic diagram showing a positive-capacitance change in an embodiment of the present disclosure.
FIG. 12 is a schematic diagram showing a negative-capacitance change in an embodiment of the present disclosure.
FIG. 13 is a schematic diagram showing a structure of an apparatus for heat-source type identification provided by the present disclosure.
FIG. 14 is a schematic block diagram showing an internal structure of a terminal device provided by an embodiment of the present disclosure.

### DETAILED DESCRIPTION OF EMBODIMENTS

The following clearly and completely describes the technical solutions of the present disclosure with reference to the embodiments and the accompanying drawings. Based on the embodiments of the present disclosure, all other embodiments obtained by those ordinary skilled in the art without creative efforts shall fall within the protection scope of the present disclosure.

After research, a temperature may be measured by a temperature sensor, and corresponding temperature control may be achieved based on the measured temperature. However, the temperature measured in the prior art is merely a magnitude of the temperature, and a type of a heat source that generates the temperature cannot be identified, that is, temperature measurement in the prior art is limited to the magnitude of the temperature. The types of heat sources include thermal radiation, thermal convection, and thermal conduction. In the thermal radiation, the heat source exchanges heat with an object based on the principle of blackbody radiation, and since there is no direct contact, only a temperature stimulus affects the object; for example, the sun as the heat source is the thermal radiation type. The thermal convection occurs when a fluid interacts with the object, and generates the temperature stimulus and a slight pressure stimulus; for example, an air gun as the heat source that blows hot air to heat the object is the thermal convection type. When the heat source and the object are in direct contact, a proximity stimulus, the pressure stimulus, and the temperature stimulus are generated to affect the object, which means that the heat source is the thermal conduction type.

In order to solve the above technical problem, the present disclosure provides a method and apparatus for heat-source type identification, a device, and a storage medium, which solves the problem that the prior art can only measure the magnitude of the temperature and cannot identify the type of the heat source that generates the temperature. In an implementation, during a process in which a capacitive temperature sensor senses an external temperature, a bulk capacitance and bulk resistance of the capacitive temperature sensor are collected, and capacitance change information of the bulk capacitance is determined; then, based on the bulk capacitance and the bulk resistance, an ionic relaxation time of ionic gel of the capacitive temperature sensor is determined; and finally, based on the capacitance change information and the ionic relaxation time, a type of a heat source corresponding to the external temperature is identified.

For example, the capacitive temperature sensor may be arranged at a prosthesis to form an electronic skin of the prosthesis for sensing the external temperature. The capacitive temperature sensor may be a multimodal temperature sensor. The bulk capacitance and bulk resistance of the electronic skin may be collected, and the capacitance change information of the bulk capacitance over time may be determined. Based on the bulk capacitance and the bulk resistance, the ionic relaxation time may be calculated. Then, based on the ionic relaxation time and the capacitance change information, the type of the heat source providing the temperature may be determined, so as to adjust a temperature of the prosthesis based on the heat-source type, thereby preventing performance degradation or damage of the prosthesis caused by overheating or overcooling, and thus improving a use efficiency and service life of the prosthesis.

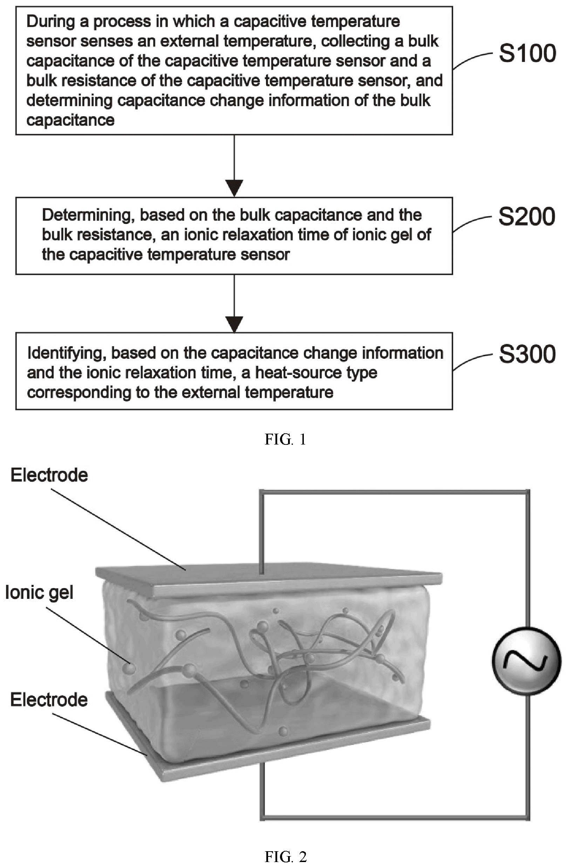

A method for heat-source type identification according to an embodiment may be applied to a terminal device. The terminal device may be a terminal product with a video playing function, such as a prosthetic controller. In the present embodiment, as shown in FIG. 1, the method for heat-source type identification may include step S100, step S200, and step S300.

Step S100: during a process in which a capacitive temperature sensor senses an external temperature, collecting a bulk capacitance of the capacitive temperature sensor and a bulk resistance of the capacitive temperature sensor, and determining capacitance change information of the bulk capacitance.

Step S200: determining, based on the bulk capacitance and the bulk resistance, an ionic relaxation time of ionic gel of the capacitive temperature sensor.

In an embodiment, the ionic gel may be ionic thermoelectric gel different from ordinary ionic gel.

Step S300: identifying, based on the capacitance change information and the ionic relaxation time, a heat-source type corresponding to the external temperature.

In an embodiment, the capacitive temperature sensor in step S100 may have a structure as shown in FIG. 2. As shown in FIG. 2, the capacitive temperature sensor may include two electrodes and the ionic gel located between the two electrodes, and the two electrodes and the ionic gel may form a sandwich structure.

In an embodiment, the capacitive temperature sensor in step S100 may be prepared by: using methoxy polyethylene glycol diacrylate (mPEG-DA) as a solvent and lithium bis(pentafluoroethylsulfonyl)imide (Li-PFSI) as a solute, stirring and mixing the solvent and the solute to form a mixture; placing the mixture on a first electrode, and curing the mixture until the mixture is cured into the ionic gel; and attaching a second electrode to the ionic gel to form the capacitive temperature sensor.

In the present embodiment, the mPEG-DA may be used as a monomer solvent, and the Li-PFSI may be used as an electrolyte salt solute. After the mPEG-DA and the Li-PFSI are mixed together, a concentration of the Li-PFSI may be 0.1 mol/L, and thorough stirring may be performed after the mixing. The mixture stirred uniformly may be dropped onto an electrode and placed into an ultraviolet (UV) curing machine for 30 minutes. After the mixture is cured into the ionic gel, another electrode may be attached to the ionic gel to form a capacitive multimodal temperature sensor, i.e., the capacitive temperature sensor.

In an embodiment, the capacitive temperature sensor prepared in the above embodiment may be tested by step S001, step S002, step S003, and step S004.

Step S001: performing heat transfer between a test heat source with a known heat-source type and the capacitive temperature sensor, collecting a test bulk capacitance of the capacitive temperature sensor and a test bulk resistance of the capacitive temperature sensor, and determining test capacitance change information of the test bulk capacitance.

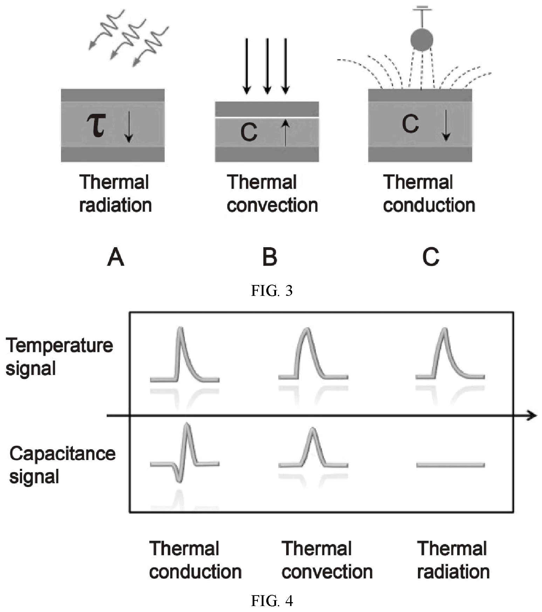

In the present embodiment, the capacitive temperature sensor may be arranged at a prosthesis, and the test heat source may be the sun, an air gun, or a finger. The heat-source type corresponding to the sun is the thermal radiation, the heat-source type corresponding to the air gun is the thermal convection, and the heat-source type corresponding to the finger when the finger contacts the prosthesis is the thermal conduction. Heat transfer mechanisms of the thermal radiation, thermal convection, and thermal conduction may be as shown in FIG. 3. Since heat generated by a heat source of the thermal convection type forms a pressure stimulus on the capacitive temperature sensor, the capacitive temperature sensor may be deformed, thereby causing a capacitance of the capacitive temperature sensor to change. A heat source of the thermal conduction type, during approaching the capacitive temperature sensor, may change a charge distribution on an electrode surface of the capacitive temperature sensor, thereby causing the capacitance of the capacitive temperature sensor to change. Therefore, during heat exchange between the heat source and the capacitive temperature sensor, the capacitance of the capacitive temperature sensor may change.

The heat transfer may be performed on the prosthesis using one of the above three types of heat sources, the test bulk capacitance and test bulk resistance of the capacitive temperature sensor may be collected, and the change information of the test bulk capacitance over time may be calculated.

Step S002: determining, based on the test bulk capacitance and the test bulk resistance, an ionic relaxation test time of the ionic gel of the capacitive temperature sensor.

Step S003: determining, based on the test capacitance change information and the ionic relaxation test time, a heat-source test type of the external temperature.

Step S004: obtaining, based on the heat-source test type and the known heat-source type, a test result for the capacitive temperature sensor.

When the known heat-source type is the thermal convection and the heat-source test type is the thermal conduction, the test result is that the capacitive temperature sensor is unqualified. On the contrary, when the heat-source test type calculated by using the bulk capacitance and bulk resistance of the capacitive temperature sensor is the thermal convection, i.e., when the heat-source test type is the same as the known heat-source type, the capacitive temperature sensor is qualified.

In an embodiment, the determining capacitance change information of the bulk capacitance in step S100 may include step S101 and step S102:
S101: determining increase or decrease information of a capacitance value of the bulk capacitance over time; and
S102: determining, based on the increase or decrease information of the capacitance value over time, a positive or negative change direction of the bulk capacitance, and using the positive or negative change direction as the capacitance change information.

In the present embodiment, the increase or decrease information of the capacitance value of the capacitive temperature sensor may be calculated to identify the type of the heat source that transfers heat to the capacitive temperature sensor. A principle adopted in the present embodiment is as shown in FIG. 4. It can be seen from FIG. 4 that, during the thermal radiation, there is only a temperature response, i.e., only the temperature changes, and there is no capacitance response. During the thermal convection or the thermal conduction, there is not only the temperature response but also the capacitance response.

A calculation process of the ionic relaxation time *τ* in step S200 is as follows: the ionic relaxation time *τ* is equal to the bulk capacitance *C* multiplied by the bulk resistance *R*, i.e., *τ*=*RC.*

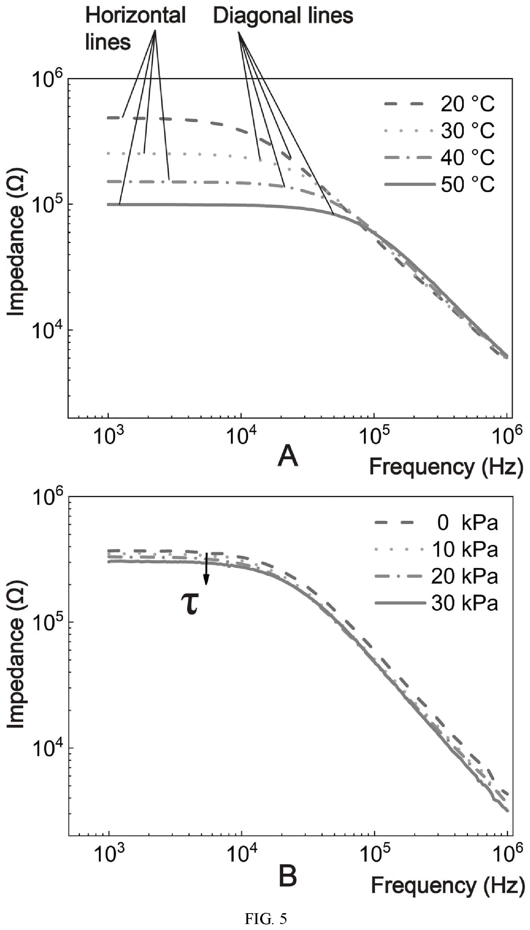

FIG. 5 shows Bode diagrams of the ionic gel at different temperatures. It may be determined from FIG. 5 that a factor that affects the ionic relaxation time *τ* is only the temperature, and the ionic relaxation time *τ* is not affected by a pressure, where the pressure comes from a pressure stimulus generated by direct contact between a heat source corresponding to thermal conduction and an object.

Horizontal lines in diagram A of FIG. 5 are obtained by measuring an impedance of the capacitive temperature sensor. By connecting upper and lower electrodes of the sensor to a fixture of a precision impedance analyzer, the impedance of the capacitive temperature sensor may be obtained. Diagonal lines are also obtained by measuring a parameter of the capacitive temperature sensor. A frequency at an intersection point of the diagonal line and the horizontal line is an ionic relaxation frequency, and a reciprocal of the ionic relaxation frequency is the ionic relaxation time. Horizontal lines and diagonal lines in diagram B are plotted in the same manner.

In an embodiment, step S300 may include step S301, step S302, and step S303.

Step S301: determining, based on the ionic relaxation time *τ*, a temperature value *T* at each time instant corresponding to the external temperature.$ln \left(τ\right) = 4752.53 / T + 26.90931 .$

In the above formula, a value range of *T* may be from -20°C to 180°C. Only when the external temperature *T* is within the above range can the specific value of *T* be calculated by using the formula.

Since *τ*=*RC*, ln(*τ*)=4752.53/*T*+26.90931 may be rewritten as the following formula:
$ln \left(RC\right) = 4752.53 / T + 26.90931 .$

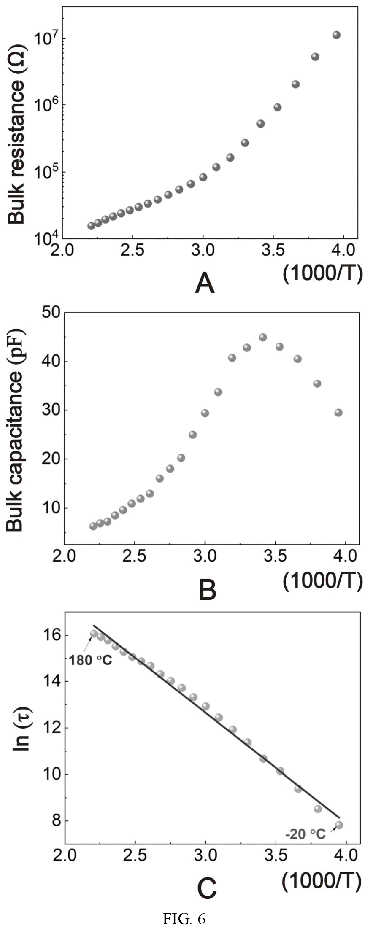

Since a change in the temperature value *T* may cause a change in the bulk capacitance *C*, a change in the bulk resistance *R*, and a change in ln(*τ*), the temperature value *T* may be calculated by using the bulk capacitance *C* and the bulk resistance *R*. *C*, *R*, and ln(*τ*) each have a corresponding relationship with the temperature value *T*. The corresponding relationships may be represented by FIG. 6. In FIG. 6, diagram A shows the bulk resistance *R* at different temperatures *T*, diagram B shows the bulk capacitance *C* at different temperatures, and diagram C shows the ionic relaxation time *τ* at different temperatures.

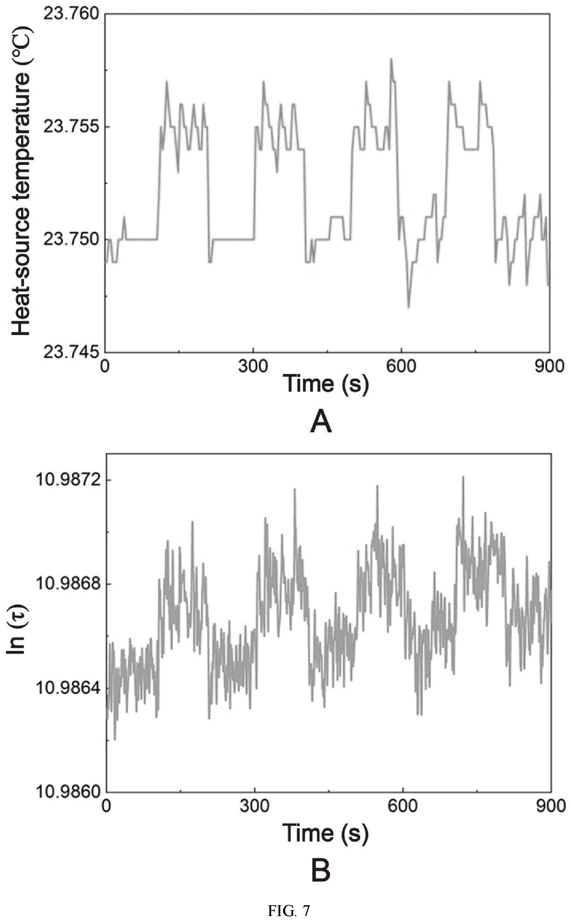

FIG. 7 shows a response result of the ionic relaxation time *τ* when the change in the temperature is 0.005°C.

The ionic relaxation time *τ* is calculated in step S200, that is, *τ* is known, and the temperature value *T* may be obtained by substituting *τ* into the above formula.

S302: determining, based on the temperature value at each time instant, temperature stability corresponding to the external temperature.

When the temperature value *T* changes greatly over time, it indicates that the temperature is unstable; otherwise, it indicates that the temperature is stable. When the temperature of an object is stable, it indicates that no heat source performs heat transfer on the object.

S303: in response to the temperature stability being unstable and the capacitance change information being zero, determining that the heat-source type is the thermal radiation.

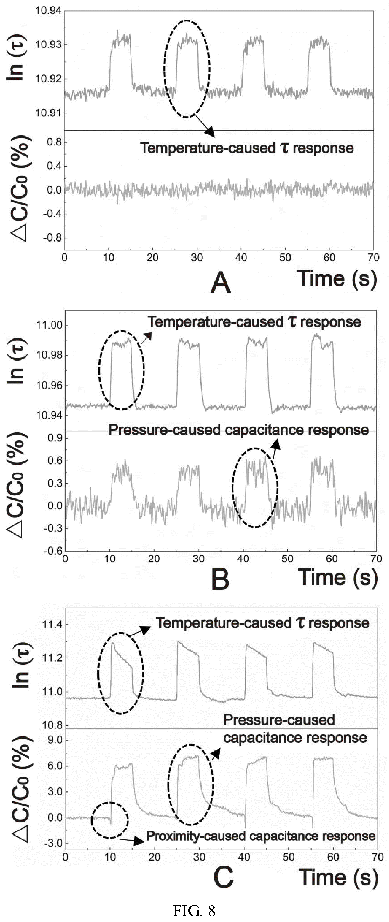

As shown in diagram A of FIG. 8, diagram A shows ln(*τ*) and capacitance *C* that are generated by the thermal radiation. When ln(*τ*) that characterizes the temperature changes, ln(*τ*) responds, and in turn, change information of the external temperature may be derived from the response of ln(*τ*).

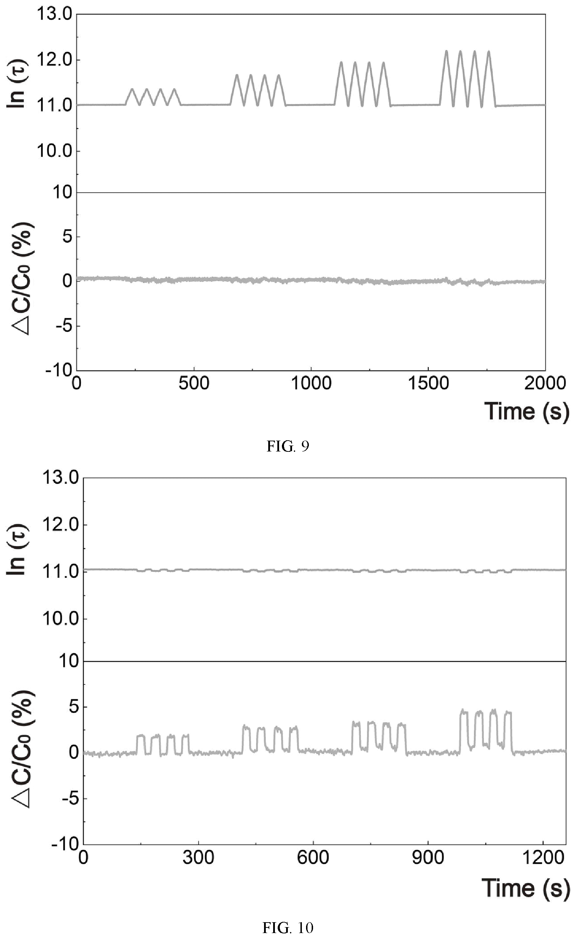

As shown in FIG. 9, for the thermal radiation, only the response of ln(*τ*) is caused, and a normalized capacitance Δ*C*/*C*₀ is not caused to change, where Δ*C* represents a changed capacitance of the capacitive temperature sensor, and *C*₀ represents an original capacitance of the capacitive temperature sensor.

As shown in FIG. 10, when the capacitive temperature sensor receives only an external pressure stimulus, the normalized capacitance of the capacitive temperature sensor changes accordingly, while the ionic relaxation time remains unchanged. Conversely, when it is detected that only the normalized capacitance of the capacitive temperature sensor changes while the ionic relaxation time remains unchanged, it is determined that the pressure stimulus received by the capacitive temperature sensor is a pressure stimulus from a non-heat source, rather than a pressure stimulus from a heat source.

In response to the temperature stability being unstable and the capacitance change information being a positive-capacitance change, the heat-source type is determined to be the thermal convection.

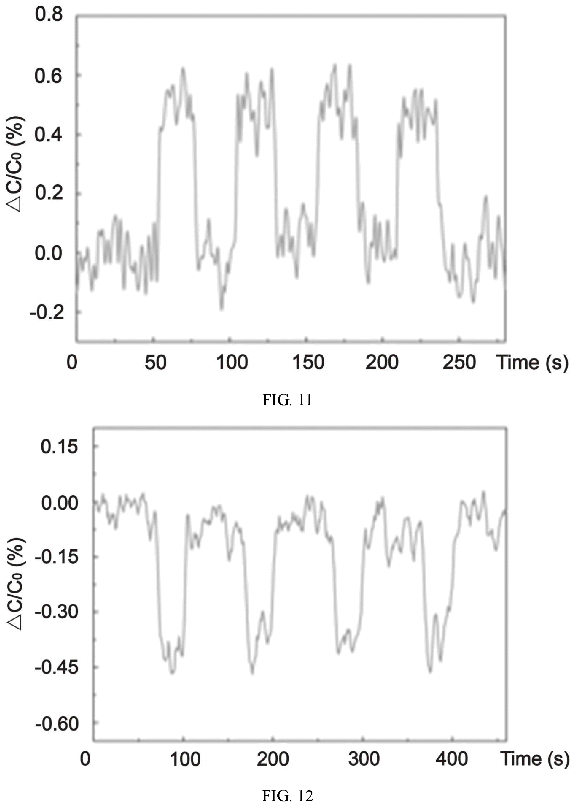

As shown in diagram B of FIG. 8, the temperature-sensitive ionic relaxation time and pressure-sensitive positive capacitance of the multimodal temperature sensor (i.e., capacitive temperature sensor) change, and the heat source is determined to be the thermal convection. Δ*C*/*C*₀ in diagram B of FIG. 8 are all greater than zero, and Δ*C*/*C*₀ greater than zero indicates the positive-capacitance change. Δ*C*/*C*₀ less than zero in diagram B of FIG. 8 is caused by disturbance of an oscilloscope. A positive change of Δ*C*/*C*₀ is as shown in FIG. 11.

In response to the temperature stability being unstable and the capacitance change information being an alternation between a negative-capacitance change and the positive-capacitance change, the heat-source type is determined to be the thermal conduction.

As shown in diagram C of FIG. 8, the temperature-sensitive ionic relaxation time, proximity-sensitive negative capacitance, and pressure-sensitive positive capacitance of the multimodal temperature sensor change, and the heat source is determined to be the thermal conduction. Δ*C*/*C*₀ in diagram C of FIG. 8 includes values greater than zero and values less than zero. The value less than zero corresponds to the negative-capacitance change, and the value greater than zero corresponds to the positive-capacitance change. A negative change of Δ*C*/*C*₀ is as shown in FIG. 12.

In summary, the multimodal thermal sensing signal model based on heat-source signal differences proposed by the present disclosure may accurately distinguish and identify heat sources under three heat exchange manners (i.e., the thermal radiation, the thermal convection, and the thermal conduction), and may be used to design temperature sensors.

The capacitive multimodal temperature sensor prepared by the present disclosure has a good linear response to the temperature stimulus, and not only has an ultra-wide operating range, but also has an ultra-high precision.

The capacitive multimodal temperature sensor prepared by the present disclosure may decouple a temperature signal and a pressure signal by using the temperature-sensitive ionic relaxation time *τ* and the pressure-sensitive normalized capacitance Δ*C*/*C*₀ , and in combination with a proximity sensing capability of the capacitive multimodal temperature sensor itself, multi-dimensional sensing of heat-source signals is achieved.

It has been proved in a heat-source test experiment that the capacitive multimodal sensor prepared by the present disclosure has different response signals under different heat sources, thereby achieving identification of the heat sources. The thermal radiation has only the temperature response. The thermal convection has the temperature response and the positive-capacitance change caused by the pressure stimulus. The thermal conduction has the temperature response, the negative-capacitance change caused by the proximity stimulus, and the positive-capacitance change caused by the pressure stimulus.

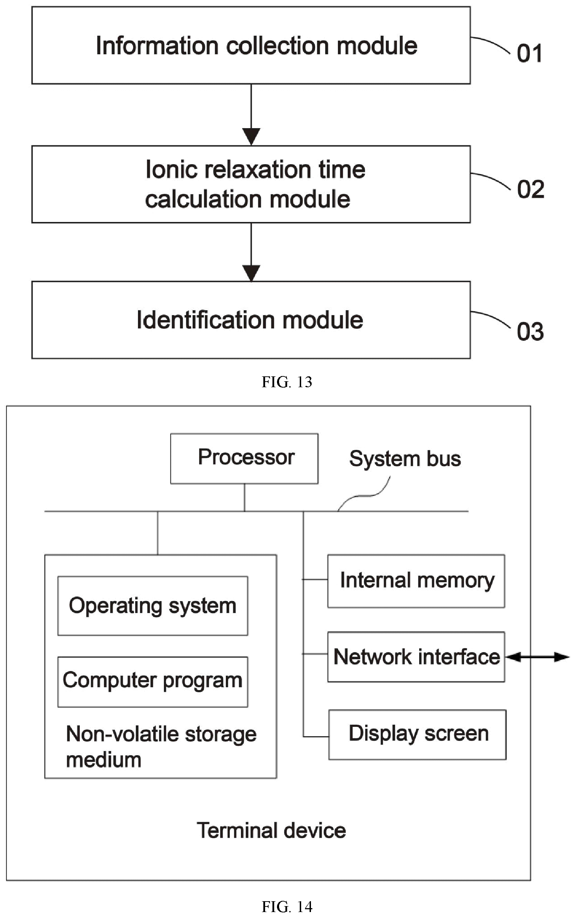

An embodiment provides an apparatus for heat-source type identification. As shown in FIG. 13, the apparatus may include the following components:
an information collection module 01 configured to: during a process in which a capacitive temperature sensor senses an external temperature, collect a bulk capacitance of the capacitive temperature sensor and a bulk resistance of the capacitive temperature sensor, and determine capacitance change information of the bulk capacitance;
an ionic relaxation time calculation module 02 configured to: determine, based on the bulk capacitance and the bulk resistance, an ionic relaxation time of ionic gel of the capacitive temperature sensor; and
an identification module 03 configured to: identify, based on the capacitance change information and the ionic relaxation time, a heat-source type corresponding to the external temperature.

Based on the above embodiments, the present disclosure further provides a terminal device. FIG. 14 shows a schematic block diagram of the terminal device, and the terminal device may include a processor, a memory, a network interface, and a display screen that are connected through a system bus. The processor of the terminal device may provide computing and control capabilities. The memory of the terminal device may include a non-volatile storage medium and an internal memory. The non-volatile storage medium may store an operating system and a computer program. The internal memory may provide an environment for running the operating system and computer program in the non-volatile storage medium. The network interface of the terminal device may communicate with an external terminal through a network. When the computer program is executed by the processor, the method for heat-source type identification is implemented. The display screen of the terminal device may be a liquid crystal display screen or an electronic ink display screen.

Those skilled in the art can understand that the schematic block diagram shown in FIG. 14 is only a block diagram of a partial structure related to the solutions of the present disclosure, and does not constitute a limitation on the terminal device to which the solutions of the present disclosure are applied. The terminal device may include more or fewer components than those shown in the figure, or combine some components, or have a different arrangement of components.

In an embodiment, a terminal device is provided. The terminal device may include a memory, a processor, and a program for heat-source type identification stored in the memory and executable by the processor. When the processor executes the program for heat-source type identification, the following operation instructions are implemented:
during a process in which a capacitive temperature sensor senses an external temperature, collecting a bulk capacitance of the capacitive temperature sensor and a bulk resistance of the capacitive temperature sensor, and determining capacitance change information of the bulk capacitance;
determining, based on the bulk capacitance and the bulk resistance, an ionic relaxation time of ionic gel of the capacitive temperature sensor; and
identifying, based on the capacitance change information and the ionic relaxation time, a heat-source type corresponding to the external temperature.

Those ordinary skilled in the art can understand that all or some of the steps in the above method embodiments may be implemented by a computer program instructing relevant hardware. The computer program may be stored in a non-volatile computer-readable storage medium. When the computer program is executed, the steps of the above method embodiments described above are implemented. Any reference to a memory, storage, database, or other medium used in the embodiments provided in the present disclosure may include a non-volatile and/or a volatile memory. The non-volatile memory may include a read-only memory (ROM), a programmable ROM (PROM), an electrically programmable ROM (EPROM), an electrically erasable programmable ROM (EEPROM), or a flash memory. The volatile memory may include a random access memory (RAM) or an external cache memory. By way of illustration but not limitation, the RAM is available in many forms, such as a static RAM (SRAM), a dynamic RAM (DRAM), a synchronous DRAM (SDRAM), a double data rate SDRAM (DDRSDRAM), an enhanced SDRAM (ESDRAM), a Synchlink DRAM (SLDRAM), a Rambus direct RAM (RDRAM), a direct Rambus dynamic RAM (DRDRAM), and a Rambus dynamic RAM (RDRAM), etc.

Finally, it should be noted that the above embodiments are only used to illustrate the technical solutions of the present disclosure, rather than to limit the present disclosure. Although the present disclosure is described in detail with reference to the above embodiments, those ordinary skilled in the art should understand that modifications may be made to the technical solutions described in the above embodiments, or equivalent replacements may be made to some of the technical features therein. These modifications or replacements do not cause the essence of the corresponding technical solutions to depart from the spirit and scope of the technical solutions of the embodiments of the present disclosure.

## Claims

1. A method for heat-source type identification, the method comprising:
during a process in which a capacitive temperature sensor senses an external temperature, collecting a bulk capacitance of the capacitive temperature sensor and a bulk resistance of the capacitive temperature sensor, and determining capacitance change information of the bulk capacitance;
determining, based on the bulk capacitance and the bulk resistance, an ionic relaxation time of ionic gel of the capacitive temperature sensor; and
identifying, based on the capacitance change information and the ionic relaxation time, a heat-source type corresponding to the external temperature.

2. The method for heat-source type identification according to claim 1, wherein determining the capacitance change information of the bulk capacitance comprises:
determining increase or decrease information of a capacitance value of the bulk capacitance over time; and
determining, based on the increase or decrease information of the capacitance value over time, a positive or negative change direction of the bulk capacitance, and using the positive or negative change direction as the capacitance change information.

3. The method for heat-source type identification according to claim 1, wherein determining, based on the bulk capacitance and the bulk resistance, the ionic relaxation time of the ionic gel of the capacitive temperature sensor comprises:
multiplying the bulk capacitance by the bulk resistance to obtain the ionic relaxation time.

4. The method for heat-source type identification according to claim 1, wherein identifying, based on the capacitance change information and the ionic relaxation time, the heat-source type corresponding to the external temperature comprises:
determining, based on the ionic relaxation time, a temperature value at each time instant corresponding to the external temperature;
determining, based on the temperature value at each time instant, temperature stability corresponding to the external temperature; and
identifying, based on the temperature stability and the capacitance change information, the heat-source type corresponding to the external temperature.

5. The method for heat-source type identification according to claim 4, wherein identifying, based on the temperature stability and the capacitance change information, the heat-source type corresponding to the external temperature comprises:
in response to the temperature stability being unstable and the capacitance change information being zero, determining that the heat-source type is thermal radiation; or
in response to the temperature stability being unstable and the capacitance change information being a positive-capacitance change, determining that the heat-source type is thermal convection; or
in response to the temperature stability being unstable and the capacitance change information being an alternation between a negative-capacitance change and the positive-capacitance change, determining that the heat-source type is thermal conduction.

6. The method for heat-source type identification according to claim 1, wherein the capacitive temperature sensor is prepared by:
using methoxy polyethylene glycol diacrylate (mPEG-DA) as a solvent and lithium bis(pentafluoroethylsulfonyl)imide (Li-PFSI) as a solute, stirring and mixing the solvent and the solute to form a mixture;
placing the mixture on a first electrode, and curing the mixture until the mixture is cured into the ionic gel; and
attaching a second electrode onto the ionic gel to form the capacitive temperature sensor.

7. The method for heat-source type identification according to claim 1, wherein the capacitive temperature sensor is tested by:
performing heat transfer between a test heat source with a known heat-source type and the capacitive temperature sensor, collecting a test bulk capacitance of the capacitive temperature sensor and a test bulk resistance of the capacitive temperature sensor, and determining test capacitance change information of the test bulk capacitance;
determining, based on the test bulk capacitance and the test bulk resistance, an ionic relaxation test time of the ionic gel of the capacitive temperature sensor;
determining, based on the test capacitance change information and the ionic relaxation test time, a heat-source test type of the external temperature; and
obtaining, based on the heat-source test type and the known heat-source type, a test result for the capacitive temperature sensor.

8. An apparatus for heat-source type identification, the apparatus comprising:
an information collection module configured to: during a process in which a capacitive temperature sensor senses an external temperature, collect a bulk capacitance of the capacitive temperature sensor and a bulk resistance of the capacitive temperature sensor, and determine capacitance change information of the bulk capacitance;
an ionic relaxation time calculation module configured to: determine, based on the bulk capacitance and the bulk resistance, an ionic relaxation time of ionic gel of the capacitive temperature sensor; and
an identification module configured to: identify, based on the capacitance change information and the ionic relaxation time, a heat-source type corresponding to the external temperature.

9. A terminal device, comprising:
a memory, a processor, and a program for heat-source type identification that is stored in the memory and executable by the processor;
wherein when the processor executes the program for heat-source type identification, steps of the method for heat-source type identification according to any one of claims 1 to 7 are implemented.

10. A computer-readable storage medium, wherein the computer-readable storage medium stores a program for heat-source type identification, and when the program for heat-source type identification is executed by a processor, steps of the method for heat-source type identification according to any one of claims 1 to 7 are implemented.
